(19) **Europäisches Patentamt / European Patent Office / Office européen des brevets**

(11) **EP 1 590 886 B1**

(12) **EUROPEAN PATENT SPECIFICATION**

(45) Date of publication and mention
of the grant of the patent:
**30.09.2009 Bulletin 2009/40**

(51) Int Cl.:
*H03D 7/16* (2006.01)   *H03B 21/01* (2006.01)
*H04B 1/30* (2006.01)   *H04B 1/26* (2006.01)

(21) Application number: **04700660.6**

(22) Date of filing: **08.01.2004**

(86) International application number:
**PCT/CA2004/000025**

(87) International publication number:
**WO 2004/064246 (29.07.2004 Gazette 2004/31)**

(54) **Downconversion of radio frequency (RF) signals**

Abwärtsumsetzung von Radiofrequenzen (RF)-Signalen

Conversion descendante de signaux de fréquence radio (RF)

(84) Designated Contracting States:
**AT BE BG CH CY CZ DE DK EE ES FI FR GB GR HU IE IT LI LU MC NL PT RO SE SI SK TR**

(30) Priority: **08.01.2003 CA 2415917**
**08.01.2003 US 438711 P**

(43) Date of publication of application:
**02.11.2005 Bulletin 2005/44**

(73) Proprietor: **Icera Canada ULC**
**1200 Calgary, Alberta T2P 4V5 (CA)**

(72) Inventors:
• **DOSANJH, Sathwant**
**Brampton, Ontario L6S 5G1 (CA)**
• **KUNG, William**
**Stittsville, Ontario (ON), K2SA8 (CA)**
• **MANKU, Tajinder**
**Waterloo, Ontario N2L 6M7 (CA)**

(74) Representative: **Townsend, Martyn**
**Page White & Farrer**
**Bedford House**
**John Street**
**London WC1N 2BF (GB)**

(56) References cited:
**WO-A2-02/14889**

• **GROSLAMBERT J ET AL: "High spectral purity frequency sources using low noise regenerative frequency dividers" FREQUENCY CONTROL, 1991., PROCEEDINGS OF THE 45TH ANNUAL SYMPOSIUM ON LOS ANGELES, CA, USA 29-31 MAY 1991, NEW YORK, NY, USA,IEEE, US, 29 May 1991 (1991-05-29), pages 636-639, XP010040192 ISBN: 0-87942-658-6**
• **GRANT, D.: "Solving the Direct Conversion Problem" PLANET ANALOG, [Online] 12 September 2000 (2000-09-12), XP002279324 Retrieved from the Internet: <URL:http://www.planetanalog.com/printable Article.jhtml?articleID=12801318> [retrieved on 2004-05-07]**

## Description

The present invention relates generally to communications, and more specifically to an apparatus for down-conversion of RF (radio frequency) signals.

## Background of the Invention

Many communication systems modulate electromagnetic signals from baseband to higher frequencies for transmission, and subsequently demodulate those high frequencies back to their original frequency band when they reach the receiver. The original (or baseband) signal may be, for example: data, voice or video. These baseband signals may be produced by transducers such as microphones or video cameras, be computer generated, or be transferred from an electronic storage device. In general, the high frequencies provide longer range and higher capacity channels than baseband signals, and because high frequency signals can effectively propagate through the air, they can be used for wireless transmissions as well as hard wired or wave guided channels.

All of these signals are generally referred to as RF signals, which are electromagnetic signals; that is, waveforms with electrical and magnetic properties within the electromagnetic spectrum normally associated with radio wave propagation.

Wired communication systems which employ such modulation and demodulation techniques include computer communication systems such as local area networks (LANs), point-to-point communications, and wide area networks (WANs) such as the Internet. These networks generally communicate data signals over electrically conductive or optical fibre channels. Wireless communication systems which may employ modulation and demodulation include those for public broadcasting such as AM and FM radio, and UHF and VHF television. Private communication systems may include cellular telephone networks, personal paging devices, HF radio systems used by taxi services, microwave backbone networks, interconnected appliances under the Bluetooth standard, and satellite communications. Other wired and wireless systems which use RF modulation and demodulation would be known to those skilled in the art.

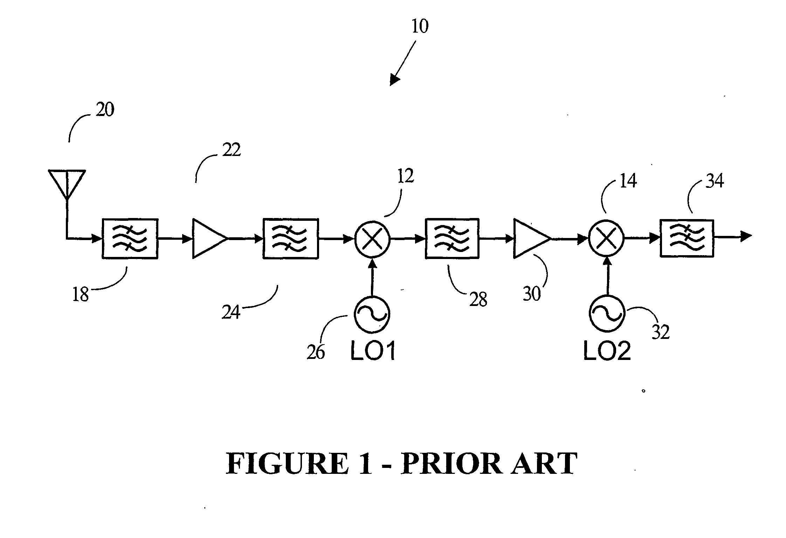

Most RF receivers use the "super-heterodyne" topology, which provides good performance in a limited scope of applications, such as in public-broadcast FM radio receivers. The super-heterodyne receiver uses a two-step frequency translation method to convert a received RF signal to a baseband signal which can be played using an audio amplifier and speaker, for example. **Figure 1** presents a block diagram of a typical super-heterodyne receiver **10.** The mixers **12** and **14** are used to translate the RF signal to baseband or to some intermediate frequency (IF). The balance of the components amplify the signal being processed and filter noise from it.

The RF band pass filter **18** first filters the signal coming from the antenna **20** (note that this band pass filter **18** may also be a duplexer). A low noise amplifier **22** then amplifies the filtered antenna signal, increasing the strength of the RF signal and reducing the noise figure of the receiver **10.** The signal is next filtered by another band pass filter **24** usually identified as an image rejection filter. The signal then enters mixer **12** which multiplies the signal from the image rejection filter **24** with a periodic signal generated by a local oscillator (LO1) **26.** The mixer **12** receives the signal from the image rejection filter **24** and translates it to a lower frequency, known as the first intermediate frequency.

Generally, a mixer is a circuit or device that accepts as its input two different frequencies and presents at its output:

   (a) a signal equal in frequency to the sum of the frequencies of the input signals;
   (b) a signal equal in frequency to the difference between the frequencies of the input signals; and
   (c) signals at the original input frequencies.

The typical embodiment of a mixer is a digital switch which may generate significantly more tones than those stated above.

The first intermediate frequency signal is next filtered by a band pass filter **28** typically called the channel filter, which is centred around the first intermediate frequency, thus filtering out the unwanted products of the first mixing processes; signals (a) and (c) above. This is necessary to prevent these signals from interfering with the desired signal when the second mixing process is performed.

The signal is then amplified by an intermediate frequency amplifier **30,** and is mixed with a second local oscillator signal using mixer **14** and local oscillator (LO2) **32.** The second local oscillator LO2 **32** generates a periodic signal which is typically tuned to the first intermediate frequency. Thus, the signal coming from the output of mixer **14** is now at baseband, that is, the frequency at which the signal was originally generated. Noise is now filtered from the signal using the low pass filter **34**, and the filtered baseband signal is passed on to some manner of presentation, processing or recording device. For example, in the case of a radio receiver, this might be an audio amplifier and speaker, while in the case of a computer modem this may be an analogue to digital convertor.

Note that the same process can be used to modulate or demodulate any electrical signal from one frequency to another.

The super-heterodyne design **10** suffers from a number of problems including the following:

- it requires expensive off-chip components, particularly band pass filters **18, 24, 28,** and low pass filter **34;**
- the off-chip components require design trade-offs that increase power consumption and reduce system gain;
- it is not fully integratable; and
- it is not easily applied to multi-standard/multi-frequency applications because the band pass and low pass filters **18, 24, 28** and **34** must be high quality devices; electronically tunable filters cannot be used. The only way to use the super-heterodyne system in a multi-standard/multi-frequency application is to use a separate set of off-chip filters for each frequency band.

Direct conversion architectures are different from super-heterodyne architectures in that they demodulate RF signals to baseband in a single step. By mixing the RF signal with a local oscillator signal at the carrier frequency, there is no image frequency, and no image components to corrupt the signal. Direct conversion receivers offer a high level of integratability, but also have several important problems.

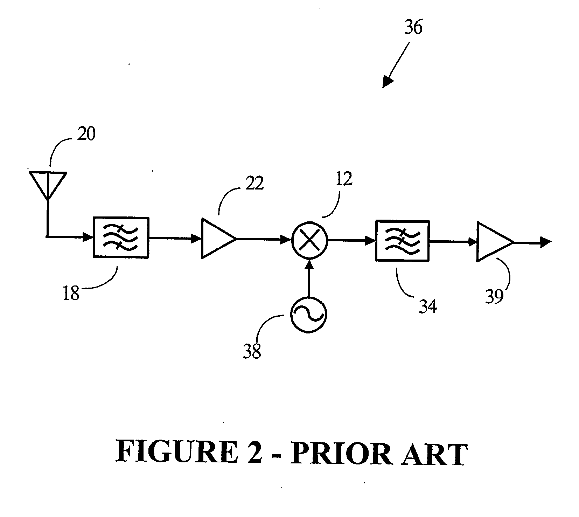

A typical direct conversion receiver **36** is presented in the block diagram of **Figure 2.** The RF band pass filter **18** first filters the signal coming from the antenna **20** (this band pass filter **18** may also be a duplexer). A low noise amplifier **22** then amplifies the filtered antenna signal, increasing the strength of the RF signal and reducing the noise figure of the receiver **36.**

The signal is then mixed with a local oscillator signal using mixer **12** and a local oscillator **38.** The local oscillator **38** generates a periodic signal which is tuned to the carrier frequency of the received signal, rather than an IF frequency as in the case of the super-heterodyne receiver **10.** The signal coming from the output of mixer **12** is now at baseband, that is, the frequency at which the received signal was originally generated. The down-converted signal is then filtered using low pass filter **34,** and may be amplified by amplifier **39.** The baseband signal can now be amplified, digitized or converted in some other way, into a useful signal.

Direct conversion RF receivers **36** have several advantages over super-heterodyne systems in term of cost, power, and level of integration, however, there are also several serious problems with direct conversion. These problems include:

- noise near baseband (that is, 1/f noise) which corrupts the desired signal;
- local oscillator (LO) leakage in the RF path which creates DC offsets. As the LO frequency is the same as the carrier frequency of the incoming signal being demodulated, any leakage of the LO signal onto the antenna side of the mixer will pass through to the output side as well;
- local oscillator leakage into the RF path which causes desensitization. Desensitization is the reduction of desired signal gain as a result of receiver reaction to an undesired signal. The gain reduction is generally due to overload of some portion of the receiver, such as automatic gain control (AGC) circuitry, resulting in suppression of the desired signal because the receiver will no longer respond linearly to incremental changes in input voltage;
- RF-LO leakage can also couple to the on-chip voltage controlled oscillator (VCO) used to generate the local oscillator signal and degrade receiver performance, especially in phase-modulated systems; and
- large on-chip capacitors are required to remove unwanted noise and signal energy near DC, which makes integrability expensive. These capacitors are typically placed between the mixer **12** and the low pass filter **34.**

Clearly, the problems listed above can be reduced significantly if the signals can be effectively isolated from one another. Unfortunately, this is very difficult to do in a cost effective and efficient way.

In "Solving the Direct Conversion Problem," Planet Analog, 12.9.00, D. Grant et al. propose a number of ways to reduce LO leakage including the following:

- good board design (for example, minimizing the length of LO traces to keep traces from acting like "antennas" which broadcast the LO signal);
- generous shielding, which can add cost and weight;
- generating an LO signal at a multiple or factor of what is required, then using a divider or multiplier to produce the actual LO where it is needed.

Grant et al. also describe the use of a simple regenerative divider circuit to produce an LO at 4/3 of the desired LO frequency, in an effort to avoid LO leakage problems.

However, Grant et al. do not offer any effective way of implementing such a circuit in an I and Q application. In many modulation schemes (particularly frequency modulation and phase modulation schemes), it is necessary to modulate or demodulate both in-phase (I) and quadrature (Q) components of the input signal, where I is 90 degrees out of phase with Q.

Simply modifying the Grant design to handle I and Q signals in the manner known in the art results in a circuit with almost as many filters and other components as required in previously known topologies. Thus, Grant et al. offer no real improvement in terms of integrability, cost and size reduction in applications requiring I and Q signals.

There is a great desire to provide modulation and demodulation circuits in a completely integrated form in the interest of providing smaller, lighter devices which are less expensive, and which consume less power. Discrete electronic components such as off-chip filters, are physically large, comparatively expensive and consume more power than integrated components. Clearly, topologies which require such off-chip components are undesirable.

However, fabricating fully-integrated receivers using cost-effective fabrication technologies is not without challenges. CMOS technology, for example, offers passive components with low quality factor and low self-resonant frequencies, which can pose problems, particularly at higher frequencies.

The continuing desire to implement low-cost, power efficient transmitters has proven especially challenging as the frequencies of interest in the wireless telecommunications industry (especially low-power cellular/micro-cellular voice/ data personal communications systems) have risen above those used previously (approximately 900 MHz) into the spectrum above 1 GHz.

Thus, there is a need for a method and apparatus for demodulation which addresses the problems above. It is desirable that this design be fully-integratable, inexpensive and high performance.

### Summary of the Invention

It is therefore an object of the invention to provide a novel method and system of demodulation which obviates or mitigates at least one of the disadvantages of the prior art, as per the appended claim 1.

### Brief Description of the Drawings

These and other features of the invention will become more apparent from the following description in which reference is made to the appended drawings in which:

**Figure 1** presents a block diagram of a super-heterodyne down-conversion topology as known in the art;

**Figure 2** presents a block diagram of a direct-conversion topology as known in the art;

**Figure 3** presents a block diagram of a synthesizer to generate narrowband oscillator signals for modulation/demodulation, in a broad embodiment of the invention;

**Figure 4** presents a block diagram of a synthesizer to generate wideband oscillator signals for modulation/demodulation, in an embodiment of the invention;

**Figure 5** presents a block diagram of a synthesizer to generate narrowband oscillator signals for modulation/demodulation, employing a notch filter, in an embodiment of the invention;

**Figure 6** presents a block diagram of a synthesizer to generate virtual local oscillator (VLO) signals for modulation/demodulation, in an embodiment of the invention;

**Figure 7** presents a timing diagram of an exemplary pair of VLO mixing signals, in an embodiment of the invention;

**Figure 8** presents a block diagram of a circuit for generating I and Q components for a VLO mixing signal, in an embodiment of the invention;

**Figure 9** presents a block diagram of a portion of the circuit in **Figure 4** so that portion of the circuit can be analysed;

**Figure 10** presents a top-level block diagram of a synthesizer for generating a complete set of VLO mixing signals for modulation/demodulation, in an embodiment of the invention;

**Figure 11** presents a block diagram of an exemplary down-converter implemented in CMOS, in an embodiment of the invention;

**Figure 12** presents a circuit diagram of a 4-section polyphase filter and amplifier used in the exemplary CMOS down-converter of **Figure 11;**

**Figure 13** presents a circuit diagram of harmonic-rejection mixer used in the exemplary CMOS down-converter of **Figure 11;**

**Figure 14** presents a die photo of the exemplary CMOS down-converter of **Figure 11;**

**Figure 15** presents a plot of quadrature error vs. input LO frequency for the exemplary CMOS down-converter of **Figure 11**; and

**Figure 16** presents a plot of calculated unwanted image suppression vs. input LO frequency for the exemplary CMOS down-converter of **Figure 11.**

### Description of the Invention

The invention uses regenerative dividers to generate the quadrature components of the local oscillator signal required for up- or down- conversion. In the case of demodulation using direct conversion, these local oscillator signals will have the same frequency as the carrier frequency of the received RF signal. The invention is generally described with respect to such a case, but clearly, the invention can be applied to the generation of local oscillator signals for any up- or down-conversion architecture.

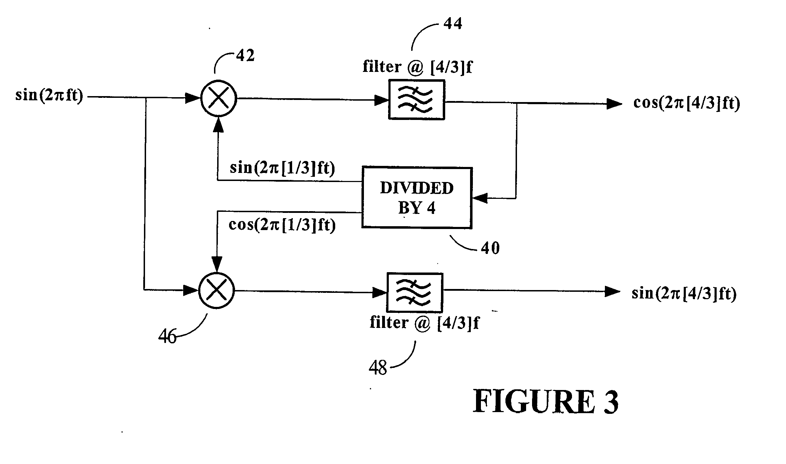

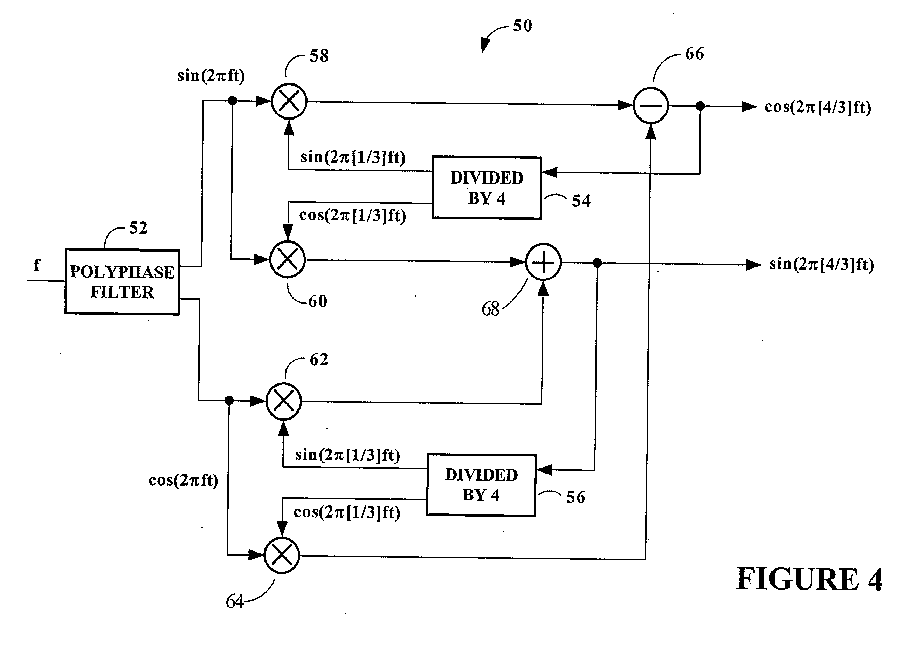

Two exemplary regenerative divider circuits which address a number of the objects of the invention are shown in the block diagrams of **Figures 3** and **4**, **Figure 3** presenting a circuit for narrow band applications, and **Figure 4** presenting a circuit for wide band applications. Both of these exemplary architectures use 3/4 of the carrier frequency as the frequency of the local oscillator signal being input to the circuit - denoted as frequency, f. That is, both circuits are designed to receive an input oscillator signal f, which has a frequency equal to 3/4 of that of the desired output frequency (the LO signal). Other divider arrangements could also be used, resulting in other relationships between the input and output frequencies.

The narrow band circuit uses a divide-by-four element **40** to generate the quadrature components at a frequency of 4/3 the incoming signal. The circuit of **Figure 3** consists of two regenerative feedback loops, both fed by the same divide-by-4 element **40**. The input oscillator signal $\sin(2\pi f t)$ is fed to a first mixer **42** where it is mixed with a $\sin(2\pi [1/3] f t)$ signal output from the divide-by-4 element **40**. The analysis of the signals can be performed as follows:

As noted above, the output of a mixer can generally be described as including the sum and difference of the two inputs, plus the inputs themselves. The two signals being fed into the first mixer **42** will be filtered by the band pass filter **44**, so they can be ignored for the sake of this analysis. This leaves two signals at the following frequencies:

$$f_{OUT} = f_{IN} + [1/4] f_{OUT} \qquad (1)$$

$$f_{OUT} = f_{IN} - [1/4] f_{OUT} \qquad (2)$$

Subtracting $[1/4] f_{OUT}$ from both sides of equation (1), it can be simplified as follows:

$$[3/4] f_{OUT} = f_{IN}$$
$$f_{OUT} = [4/3] f_{IN} \qquad (3)$$

The bandpass filter **44** is centered at $[4/3] f$, which filters out all but the desired $[4/3] f$ signal. The mixing of the two sin signals causes the output to shift to a cos signal, so the input $\sin(2\pi f t)$ becomes an output $\cos(2\pi [4/3] f t)$ signal. The bandpass filter **44** also helps remove harmonics produced by the divide-by-4 element **40** and the first mixer **42** (when manipulating RF signals, harmonic signals are often generated - harmonics are simply integral multiples of the frequency of the sinusoid waves being handled. The frequency of the sinusoid wave is called the fundamental frequency or the first harmonic, the second harmonic is twice the fundamental frequency, the third harmonic is thrice the fundamental frequency, etc.)

The other leg of this circuit operates in much the same way. However, rather than mixing the input oscillator signal $\sin(2\pi f t)$ with a $\sin(2\pi [1/3] f t)$ signal output from the divide-by-4 element **40,** it is mixed with a $\cos(2\pi [1/3] f t)$ signal using a second mixer **46**. When this mixed signal is passed through the second bandpass filter **48,** the output is the desired $\sin(2\pi [4/3] f t)$ signal.

Thus, this circuit generates a quadrature pair of LO signals at 4/3 of the frequency of the incoming signal. As noted, having a local oscillator (LO) at the same frequency as that of the incoming signal can allow self-mixing to occur, degrading system performance. Using signals at a different frequency than that of the incoming signal x(t) reduces the degree of self-mixing. Note that the component count and form factor of the design of the invention is much less than that of the prior art circuits.

The two signal branches (i.e. **42** and **44** being one branch, and **46** and **48** being the other) should be as symmetric as possible. It may be necessary to attach a dummy divide-by-4 element to the bottom branch to increase the amount of symmetry (the dummy divider would be attached only at its input, and the output of the dummy would be unattached).

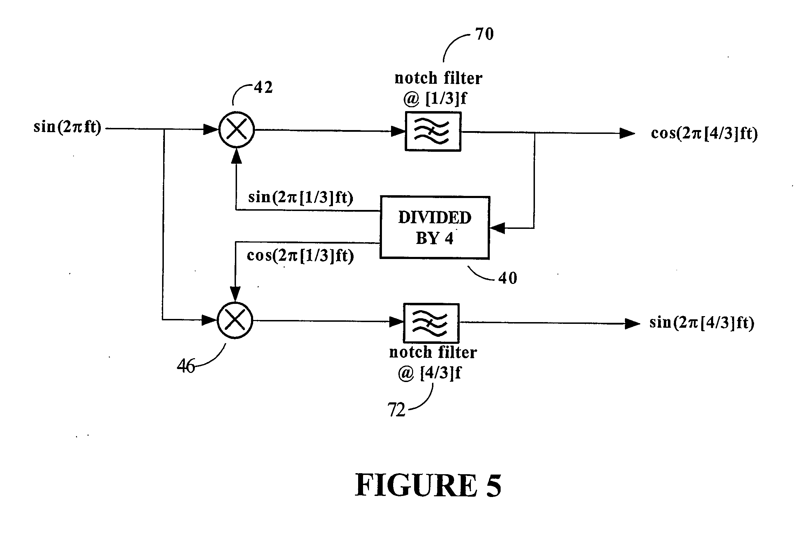

One of the harmonics that needs to be removed is the one at 1/3 of the f frequency. This harmonic can be removed using bandpass filters **44, 48** as shown in **Figure 3** or using notch filters **70, 72** centered at $[1/3] f$ as shown in **Figure 5**. In the wide band circuit **50** of **Figure 4**, the $[1/3] f$ signal is removed using a quadrature subtraction technique, and a poly-phase filter **52** is used to produce quadrature elements of the LO.

The circuit **50** of **Figure 4** consists of four regenerative feedback loops, employing two divide-by-4 elements **54, 56**. The input oscillator signal with a frequency of f, is fed to a polyphase filter **52** which produces quadrature oscillator signals sin(2π f t) and cos(2π f t). These two oscillator signals are fed to a pair of regenerative feedback circuits which are, individually, much like that of **Figure 3.**

Polyphase filters are selective filters which can discriminate between positive and negative frequencies. Their usual application is with regard to the removal of image signals when modulating and demodulating RF signals. The polyphase filter **52** of **Figure 4**, is being used for quite a different purpose.

The sin(2π f t) oscillator signal is fed to a pair of mixers **58, 60** which mix this oscillator signal respectively, with sin(2π [1/3] f t) and cos(2π [1/3] f t) signals from the divide-by-4 element **54.** The same process occurs to the cos(2π f t) oscillator signal which is fed to a pair of mixers **62, 64** which mix this oscillator signal, respectively, with sin(2π [1/3] f t) and cost(2π [1/3] f t) signals from the divide-by-4 element **56**. In general, these mixers **58, 60, 62, 64** would be harmonic rejection mixers (HRMs).

Rather than using a bandpass filter to remove the unwanted signal components from the mixer outputs, as in **Figure 3**, this circuit **50** uses quadrature subtraction. The output of mixer **64** is subtracted from the output of mixer **58** using adder **66,** leaving a single signal: cos(2π[4/3] f t). Similarly, the output of mixer **60** is summed with the output of mixer **62** using adder **68,** leaving the signal: sin(2π[4/3] f t). Techniques other than filtering or quadrature subtraction could also be used to cancel, remove, or ignore the unnecessary signals.

Note that particular design parameters for the mixers of **Figures 3 - 5** would be clear to one skilled in the art, having the typical properties of an associated noise figure, linearity response, and conversion gain. The selection and design of these mixers would follow the standards known in the art.

Though these figures imply that various elements are implemented in analogue form, they can also be implemented in digital form. The mixing signals are typically presented herein in terms of binary 1s and 0s, however, bipolar waveforms, ±1, may also be used. Bipolar waveforms are typically used in spread spectrum applications because they use commutating mixers which periodically invert their inputs in step with a local control signal (this inverting process is distinct from mixing a signal with a local oscillator directly).

As well, the invention was described above with respect to the terms "narrowband" and "wideband". These terms are usually subjectively defined, relative to the context. A narrowband signal is generally a signal whose spectral content is limited to a narrow channel; typically ~20MHz for a single wireless standard. In contrast, "wideband" generally refers to a bandwidth of >20MHz, or a multiple of a wireless standard.

The invention was also described in the context of a direction-conversion application, but of course, the invention could easily be applied to other methodologies. Near Zero-IF (or Low-IF) is a typical example.

Near Zero-IF conversion is similar to direct conversion, in that the RF band is brought close to baseband in a single step. However, with Near Zero-IF the desired signal is not brought exactly to baseband, and therefore DC offsets and 1/f noise do not contaminate the signal.

**Exemplary Implementation with VLO (Virtual Local Oscillator) Signals**

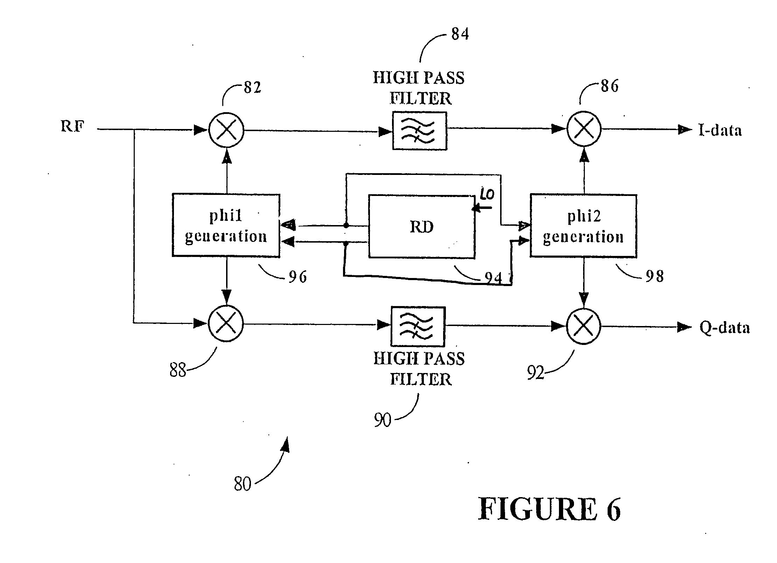

An implementation of the invention with respect to "virtual local oscillator" (VLO) signals is presented in **Figures 6 - 10**. As will be described, VLO signals are pairs of mixing signals φ1 and φ2 which can be used for up-converting or down-converting. While two mixing signals are required, they are very different from the two mixing signals used in normal two-step conversion topologies such as superheterodyne topologies. The main difference from the direct-conversion approach is that two mixing signals of the invention are used emulate a single mixing signal, but they do this without the usual short comings of direct-conversion, such as self-mixing.

As shown in the block diagram of the VLO topology **80** in **Figure 6**, the input signal RF is mixed with a multi-tonal mixing signal φ1 using a first mixer **82** (multi-tonal, or non-mono-tonal, refers to a signal having more than one fundamental frequency tone. Mono-tonal signals have one fundamental frequency tone and may have other tones that are harmonically related to the fundamental tone). The resulting signal, φ1 x(t), is then passed through a high pass filter **84,** and is mixed with a mono-tonal signal φ2 by means of a second mixer **86,** generating an in-phase output signal φ1 φ2 x(t). These mixing signals φ1 and φ2 are generally referred to herein as "virtual local oscillator" (VLO) signals because they emulate a local oscillator signal. The product φ1 * φ2 has significant power at the frequency of a local oscillator signal being emulated. However, neither φ1 nor φ2 have significant power at the frequency of the input signal x(t), the LO signal being emulated; or the output signal φ1 φ2 x(t). Mixing signals with such characteristics greatly resolve the problem of self-mixing because the VLO signals simply do not have significant power at frequencies that will interfere with the output signal.

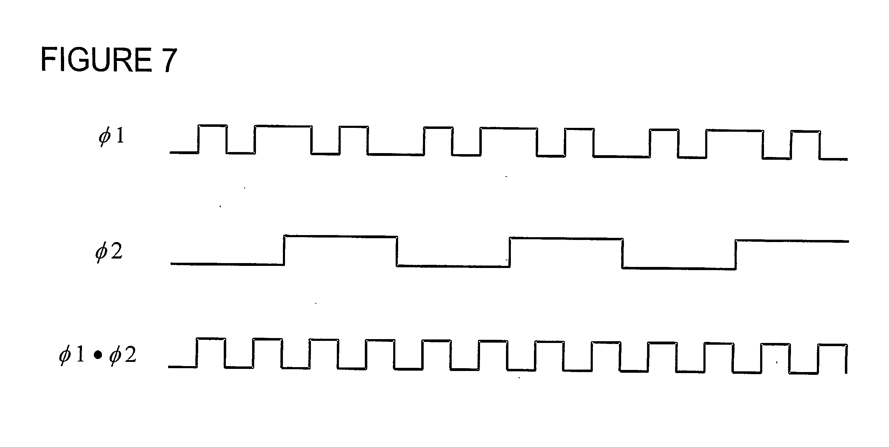

An exemplary pair of φ1 and φ2 mixing signals is presented in **Figure 7,** plotted in amplitude versus time. It is clear that the product of these two mixing signals, φ1 * φ2, is equal to the desired LO signal. Thus, the output φ1 φ2 x(t) from fixer **86** of **Figure 6** will be equal to the output of a hypothetical LO * x(t) down conversion. It is also clear from **Figure 7** that neither φ1 nor φ2 have a significant amount of power at the frequency of LO = φ1 * φ2.

In fact, at no point in the operation of the circuit is an actual "φ1 * φ2" signal ever generated and if it is, only an insignificant amount is generated. The mixers **82, 86** receive separate φ1 and φ2 signals, and mix them with the input signal x(t) using different physical components. Hence, there is no LO signal which may leak into the circuit.

Looking at one cycle of these mixing signals from **Figure 7** the generation of the φ1 * φ2 signal is clear:

**Table I - Exemplary VLO Mixing Signals**

| φ2 | φ1 | φ1 * φ2 |
|----|----|---------|
| LO | LO | LO |
| LO | HI | HI |
| LO | LO | LO |
| LO | HI | HI |
| HI | HI | LO |
| HI | LO | HI |
| HI | HI | LO |
| HI | LO | HI |

Clearly, the two mixing signals φ1 and φ2 in **Figure 7** satisfy the criteria for effective VLO signals.

In **Figure 6**, two signal channels are shown: one for an in-phase component of the input signal, consisting of mixers **82** and **86** and high pass filter **84,** and one for a quadrature component of the input signal, consisting of mixers **88** and **92** and high pass filter **90**. These two sets of mixers and filters are the same; the only difference is that the two sets of mixing signals are 90 degrees out of phase with one another.

This circuit uses a regenerative divider circuit **94** such as one described above with respect to any one of **Figures 3 - 5,** to provide in-phase and quadrature oscillator signals to the φ1 generator **96**. The φ1 generator **96** and φ2 generator **98** could be any arrangement of logic or other circuitry required to generate VLO signals as described herein. A large number of co-pending patent applications have also been filed by the Applicant describing various manners of generating such VLO signals. These patent applications include the following:

1. PCT International Application Serial No. PCT/CA00/00995 Filed September 1, 2000, titled: "Improved Method And Apparatus For Up-Conversion Of. Radio Frequency (RF) Signals";
2. PCT International Application Serial No. PCT/CA00/00994 Filed September 1, 2000, titled: "Improved Method And Apparatus For Down-Conversion Of Radio Frequency (RF) Signals";
3. PCT International Application Serial No. PCT/CA00/00996 Filed September 1, 2000, titled: "Improved Method And Apparatus For Up-And-Down-Conversion Of Radio Frequency (RF) Signals"; and
4. PCT International Application Serial No. PCT/CA01/00876 Filed June 19, 2001, titled: "Improved Method And Apparatus For Up-And-Down-Conversion Of Radio Frequency (RF) Signals".

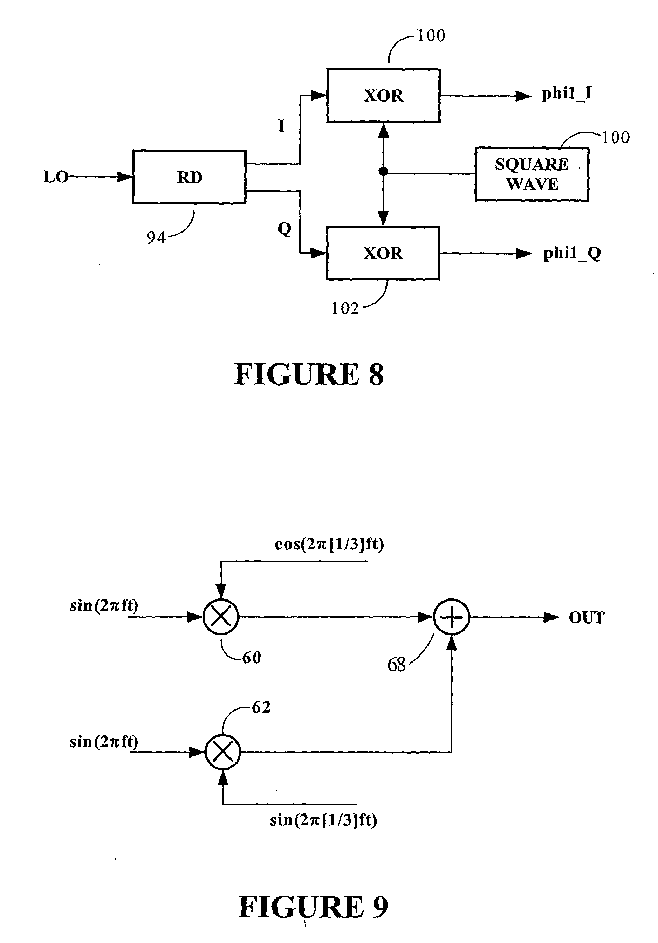

One method of generating φ1I and φ1Q is shown in the block diagram of **Figure 8**. The regenerative divider circuit **94** is the same as the one in **Figure 6,** but the φ1 generator **96** has been replaced with a pair of XOR gates **100, 102** and a square wave generator **104**. The square wave can be generated from a frequency-controlled oscillator or in some similar manner. The frequency of the square wave may be varied, as may the "digital" pattern. It is important to note though, that the square waveform has to have an average value of zero (assuming it is swinging between +1 and -1).

In this exemplary embodiment, the wideband version of the invention from **Figure 4** is being employed. **Figure 9** presents a block diagram of a portion of that circuit, so that the signals can be analysed.

As described above, the divide-by-four elements **54, 56** and the mixer configuration will cause the frequency component at f to be multiplied with a square wave signal at a frequency of [1/3] f. **Figure 9** presents a block diagram of mixers **60, 62** and adder **68** from **Figure 4,** showing the inputs to these components. Under ideal conditions and ideal matched conditions, the output of this portion of the circuit will be as follows:

**Table II: Output of Figure 9, where fundamental is 4/3*f**

| Nth tone | Relative mag. | Component (sine) | tone |
|---|---|---|---|
| 1 | 1 | (4/3)*f | fund |
| 3 | 38046 | 0*f | DC |
| 5 | 38107 | (8/3)*f | 2*fund |
| 7 | 38168 | (4/3)*f | fund |
| 9 | 38230 | 4*f | 3*fund |
| 11 | 38291 | (4/3)*f | 2*fund |
| 13 | 38352 | 4*f | 3*fund |
| 15 | 1/15 | 4*f | 3*fund |

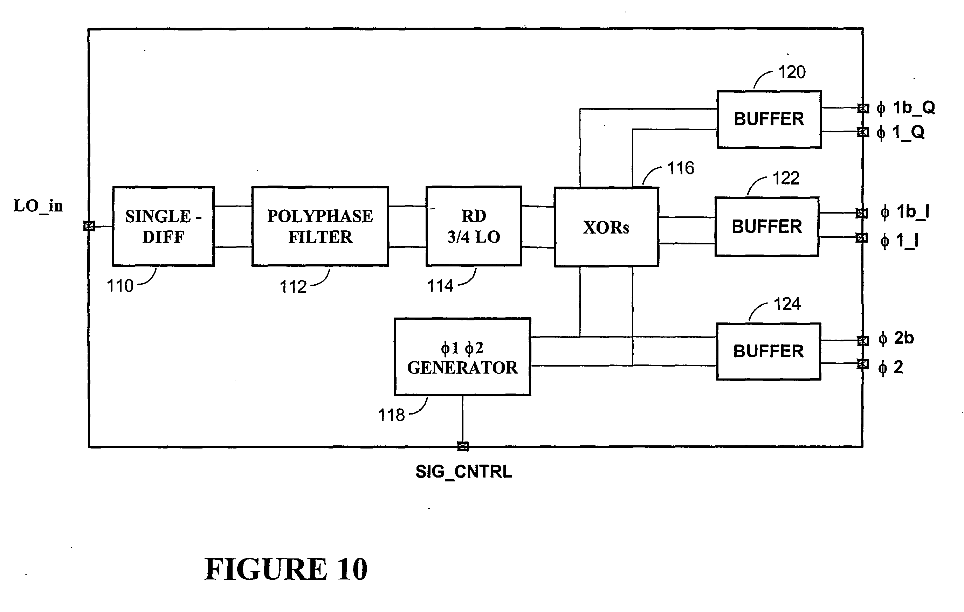

A practical embodiment of this design as a single chip, is presented in the block diagram of **Figure 10**. An single-ended oscillator signal LO_in is received and is converted to a differential signal using a linear wide band single to differential converter (range of 525 - 1875MHz) **110**. This differential signal is then fed to a differential wide band poly phase filter **112** with a frequency range of 525 - 1875MHz. Differential sin(2π ft) and cos (2π ft) signals are then sent to a differential regenerative divider **114**. Apart from the fact that this regenerative divider **114** uses differential signalling, it is the same as that of **Figure 4.**

The differential sin(2π [4/3] ft) and cos (2π [4/3] ft) signals from the differential regenerative divider **114** are then fed to a block of XOR gates, which is interconnected with the φ1 and φ2 generation block **118.** As noted above, the structure of the φ1 and φ2 generation block **118** is the subject of various co-pending patent applications. The differential φ1bI, φ1bQ, φ1I, φ1Q, φ2I and φ2Q signals are then fed through buffers **120, 122, 124** and output from the chip, so they can be connected to mixers (note that the φ1bI, φ1bQ signals the 180 degree complements of φ1I, φ1Q, required for the differential signalling).

A summary of the current estimates and frequency ranges for the components in the embodiment of **Figure 10**, are presented in the table below.

**TABLE III: Current estimates and frequency range of components**

| Element | Estimated current (mA) | Min Freq. (MHz) | Mx Freq. (MHz) | Voltage Range (mV) - Min. | Voltage Range (mV) - Max. |
|---|---|---|---|---|---|
| Single-Diff. | 1 | 525 | 1875 | | |
| Polyphase | 0 | 525 | 1875 | | |
| RD | 2 | 525 | 2500 | | |
| XORs | 1 | 700 | 2500 | | |
| Soggen | 1 | 25 | 175 | | |
| Buffers1 | 3 | 700 | 2500 | 1200 | 1800 |
| Buffers2 | 3 | 25 | 150 | 0 | 1800 |
| Total | 14 | NA | NA | | |

While this circuit contains many components that are similar to commonly used demodulation topologies, it uses them in a unique way. Thus, this circuit:

1. allows an input signal x(t) to be down-converted using a completely integratable circuit;
2. does not use mixing signals that contain significant power at the frequency of the local oscillator signal being emulated. Thus, the frequency translation is still effected, but self-mixing and unwanted mixing products are avoided; and
3. is particularly convenient when applied to the development of multistandard/multi-frequency devices because no filters are required, and because the mixing signals can be generated and varied so easily. This advantage will become more clear from the description which follows.

Other advantages of the invention will also become clear from the other embodiments of the invention described hereinafter.

**Virtual Local Oscillator Signals**

An exemplary set of VLO signals were described hereinabove. The purpose of this section is to present VLO signals in a more general way, as any number of VLO signals could be generated with which the invention could be implemented.

Aperiodic or time-varying mixing signals offer advantages over previously used mono-tonal oscillator signals. A given pair of these virtual local oscillator (VLO) signals φ1 and φ2 have the properties that:

> 1. their product emulates a local oscillator (LO) signal that has significant power at the frequency necessary to translate the input signal x(t) to the desired output frequency. For example, to translate the input signal x(t) to baseband, φ1(t) * φ2(t) must have a frequency component at the carrier frequency of x(t); and
> 2. one of either φ1 and φ2, has minimal power around the frequency of the mixer pair output φ1(t) * φ2(t) * x(t), while the other has minimal power around the centre frequency, $f_{RF}$, of the input signal x(t). "Minimal power" means that the power should be low enough that it does not seriously degrade the performance of the RF chain in the context of the particular application.
> For example, if the mixer pair is demodulating the input signal x(t) to baseband, it is preferable that one of either φ1 and φ2 has minimal power around DC.

As a result, the desired demodulation is affected, but there is little or no LO signal to leak into the signal path and appear at the output.

As noted above, mixing two signals together generates an output with:

> (a) a signal equal in frequency to the sum of the frequencies of the input signals;
> (b) a signal equal in frequency to the difference between the frequencies of the input signals; and
> (c) the original input frequencies.

Thus, direct conversion receivers known in the art must mix the input signal x(t) with a LO signal at the carrier frequency of the input signal x(t). If the LO signal of a direct conversion receiver leaks into the signal path, it will also be demodulated to baseband along with the input signal x(t), causing interference. The invention does not use an LO signal, so leakage does not generate a signal at the baseband output φ1(t)*φ2(t)*x(t).

Any signal component at the frequency of the input signal x(t) or the output signal φ1(t) * φ2(t) * x(t), in either of the mixing signals φ1 and φ2, is suppressed or eliminated by the other mixing signal. For example, if the mixing signal φ2 has some amount of power within the bandwidth of the up-converted RF (output) signal, and it leaks into the signal path, then if will be suppressed by the φ1 mixing signal which has minimal power within the bandwidth of the up-converted RF (output) signal. This complementary mixing suppresses interference from the mixing signals φ1 and φ2.

As noted above, current receiver and transmitter technologies have several problems. Direct-conversion transceivers, for example, suffer from LO leakage and 1/f noise problems which limit their capabilities, while heterodyne transceivers require image-rejection techniques which are difficult to implement on-chip with high levels of performance.

The problems of image-rejection, LO leakage and 1/f noise in highly integrated transceivers can be overcome by using the complementary VLO signals. These signals are complementary in that one of the φ1 and φ2 signals has minimal power around the frequency of the output signal y(t) (which is around DC if conversion is to baseband), and the other has minimal power around the centre frequency, $f_{RF}$, of the input signal x(t).

These signals φ1 and φ2 can, in general, be:

> 1. random or pseudo-random, periodic functions of time;
> 2. analogue or digital waveforms;
> 3. constructed using conventional or non-conventional bipolar waves;
> 4. averaging to zero;
> 5. amplitude modulated; and
> 6. generated in a number of manners including:

>> a. being stored in memory and clocked out;
>> b. being generated using digital blocks;
>> c. being generated using noise shaping elements (e.g. delta-sigma elements); or
>> d. being constructed using PN sequences with additional bits inserted so they comply to the above conditions.

It would be clear to one skilled in the art that virtual LO signals may be generated which provide the benefits of the invention to greater or lesser degrees. While it is possible in certain circumstances to have almost no LO leakage, it may be acceptable in other circumstances to incorporate virtual LO signals which still allow a degree of LO leakage.

Virtual local oscillator signals may also be generated in different forms, such as using three or more complementary signals rather than the two mixing signals shown above. As noted above, these and other variations are described in the following co-pending PCT patent applications filed under Serial Nos. PCT/CA00/00994, PCT/CA00/00995 and PCT/CA00/00996.

**Exemplary Implementation in CMOS**

The local oscillator generation scheme of the invention, for use in Low-IF and Direct Conversion architectures, was implemented in 0.18 $\mu$m CMOS. This fully-integrated, ratio-based local oscillator (LO) generation scheme uses regenerative division, and consumes 27 mW from a 1.8 V supply. The entire chip is fully integrated, including on-chip spiral inductors; harmonic rejection mixers are also employed to suppress unwanted mixing products to better than -36 dBc. Across an RF band of 150 MHz, a quadrature phase error of less than 2° and a maximum image suppression of 36 dB is achieved. Using a 4/3 multiplication factor to generate the local oscillator, LO-RF interactions are reduced and an LO-RF leakage of -86 dBm has been measured at the mixer input.

Designing a fully-integrated direct conversion receiver in CMOS is not without challenges. In addition to the RF-LO leakage problems described above, CMOS technology offers passive components with low quality factor and low self-resonant frequencies, which can pose problems for the realization of higher frequency (eg. 5 GHz) designs. As such, careful LO planning is necessary in the design of a direct conversion receiver.

This embodiment of the invention implements a fractional-based LO generation scheme in a 1.8 V, 0.18 $\mu$m, single-poly, 6- metal bulk CMOS process for direct conversion or low-IF architectures. On-chip spiral inductors and harmonic rejection mixers are used to suppress unwanted mixing products. The LO system is implemented along with direct down-conversion mixers to facilitate testing.

As noted in the Background to the Invention, others have attempted design regenerative circuits to generate local oscillator signals, but they have not provided designs which are effective in producing in-phase and quadrature LO signals. Since the LO is not generated in quadrature, a polyphase circuit could be inserted in the received RF signal path, but this polyphase would add loss and noise to the system (see F. Behbahani et al., "CMOS Mixers and Polyphase Filters for Large Image Rejection," IEEE J. Solid-State Circuits, vol. 36, pp. 873 - 886, June, 2001, for example). Other LO generation schemes have been described which require a polyphase filter at the output to generate quadrature LO, which also results in poor performance due to losses and noise.

The system which was fabricated uses regenerative division, provides quadrature LO signals without using a polyphase filter at the output, and employs harmonic-rejection mixers (HRM). Thus, this circuit provides I and Q LO components with higher quality than other integration attempts in the past.

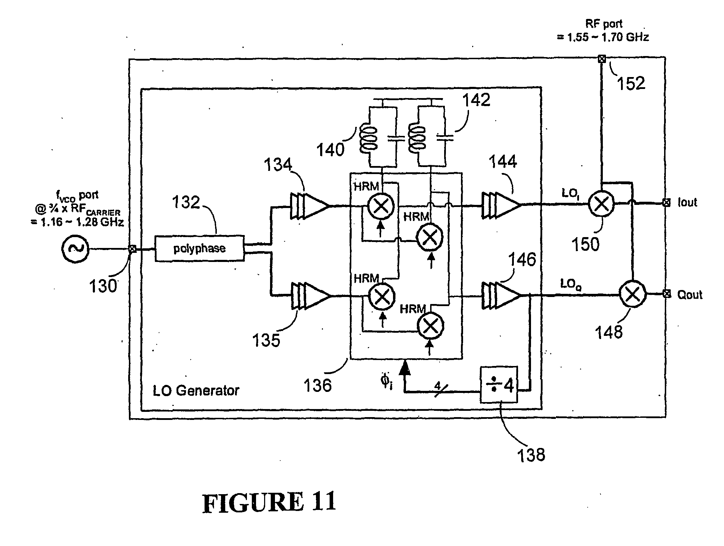

The architecture of this embodiment is presented in the block diagram of **Figure 11.** While single lines are used for each signal path in this Figure, all of the signal paths in the actual chip are fully differential. Differential signals are signals which have positive and negative potentials with respect to ground, rather than only one potential with respect to ground (for example, a measurement on a pair of wires might indicate that one if +1.3 V, while the other is -1.3V. This is in contrast to the measurements being 0 and +1.3V, for example). It would be clear to one skilled in the art, how to implement all of the components of the invention is differential form.

The use of a differential signalling results in stronger output signals and better noise resistance (particularly resistance to common mode noise) than single ended signalling. If, for example, environment noise imposes a noise signal on an input, then this noise signal will propagate through the circuit. However, if this environmental noise is imposed equally on the positive and negative inputs of a differential circuit, then the net effect will be zero.

The circuit of **Figure 11** is designed to receive an input oscillator signal at the $f_{VCO}$ port which is at 3/4 of the RF carrier frequency (i.e. the input signal is at 3/4 of the frequency of the desired output). In this particular application, this is a signal at 1.16 ~ 1.28 Ghz. This signal is referred to as a VCO signal, because generally it will be produced using a voltage controlled oscillator.

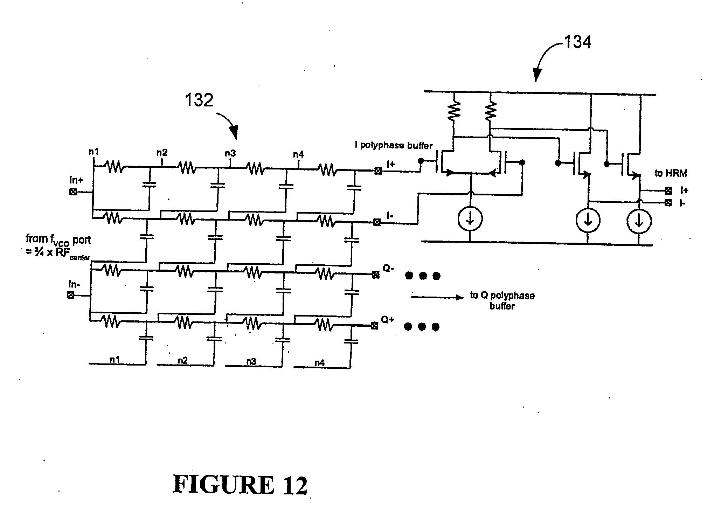

The VCO signal from the $f_{VCO}$ port **130** is fed to a stagger-tuned four-stage polyphase filter **132** which generates quadrature signals from 600 to 1795 MHz. To account for the loss of the polyphase filter **132,** it is followed by a gain stage which consists of a pair of common-source, differential amplifiers **134, 135.** The polyphase filter **132** consists of a grid-work of resistors and capacitors as shown in **Figure 12. Figure 12** also shows the specific circuit used to implement the amplifiers **134, 135.**

The amplified signals are then fed to the four harmonic rejection mixers (HRMs) **136.** A divide-by-four circuit **138** is used in feedback to generate the 4/3 multiplication factor.

A pair of tuned LC tanks **140, 142** form the load for the HRMs and are used to suppress the unwanted mixing products generated as a result of the harmonics produced by the divide-by-four circuit. An integrated 8.2 nH inductor with a quality factor of 4.5 was designed using ASITIC (see A. Niknejad and R. Meyer, "Analysis, Design, and Optimization of Spiral Inductors and Transformers for RF IC's," IEEE J. Solid-State Circuits, vol. 33, pp. 1470 - 1481, Oct., 1998).

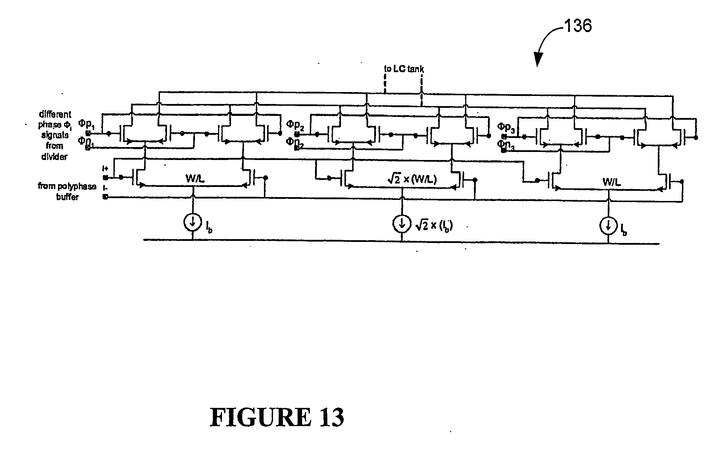

HRMs **136** were employed to relax the filtering requirements of the LC tanks **140, 142.** The HRMs **136** reduce the mixer products generated by the 3rd and 5th harmonics of the divide-by-four circuit **138.** The HRMs **136** are based on Gilbert-cell mixers as shown in **Figure 13.** The phase delayed signals (φ) required by the HRMs **136** are provided by the divide-by-four circuit **138.** The φi signals are weighted and delayed to achieve correct harmonic cancellation (see J. A. Weldon et. al., "A 1.75-GHz Highly Integrated Narrow-Band CMOS Transmitter with Harmonic-Rejection Mixers," IEEE J. Solid- State Circuits, vol. 36, pp. 2003-2015, Dec., 2001).

The inputs to the HRMs **136** are applied in quadrature to two sets of HRM pairs. This reduces various mixer products and also provides quadrature LO outputs.

The quadrature LO signals are then amplified by a pair of amplifiers **144, 146** and are applied to a pair of down-conversion mixers **148, 150.** The oscillator signals are mixed with an RF signal received via the RF port **152,** provide baseband in-phase and quadrature outputs at ports **154, 156.**

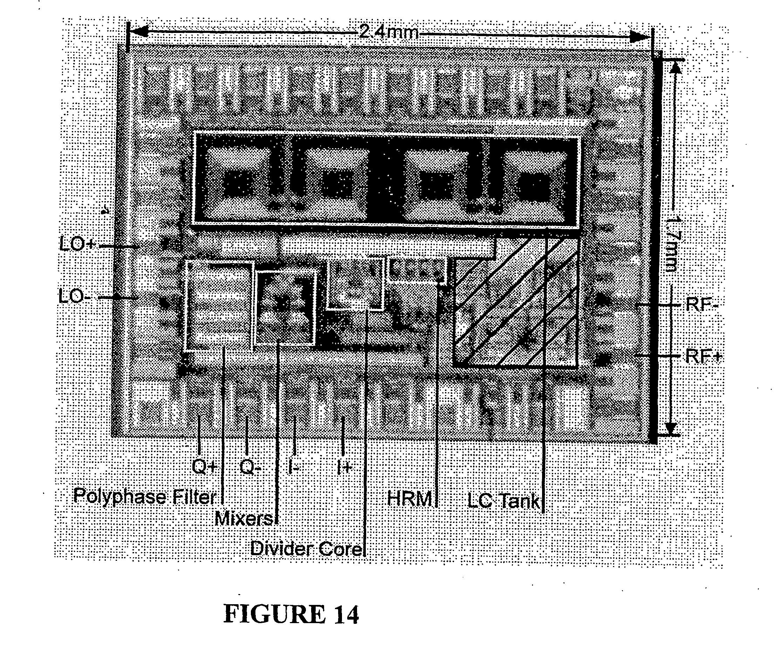

A die photo of the implemented system is shown in **Figure 14.** The system, excluding the pad frame, occupies an area of approximately 1.5 mm$^2$.

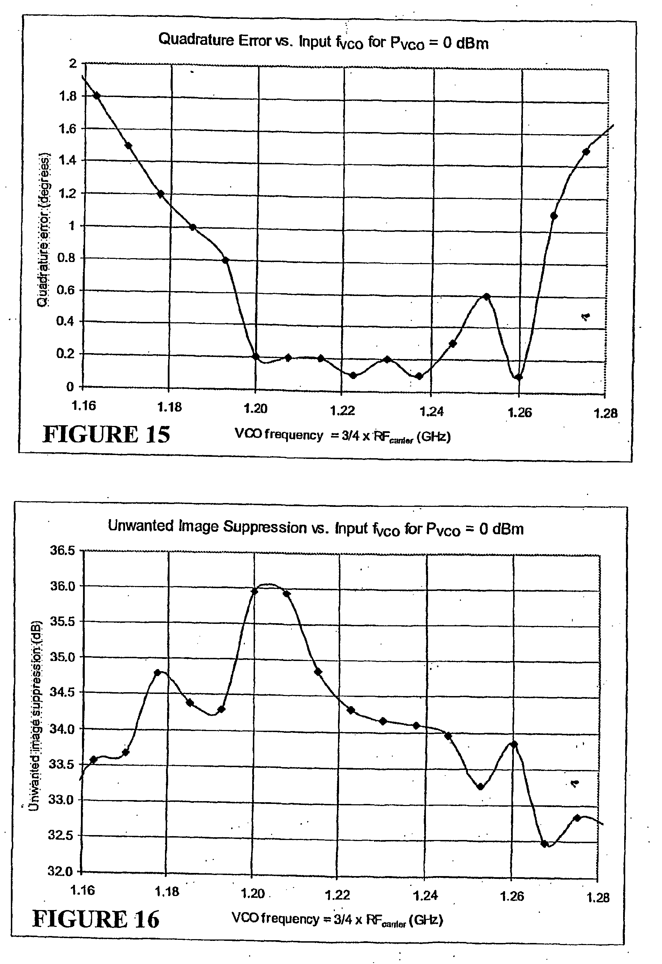

Across an input $f_{VCO}$ range of 1.16 to 1.28 GHz (equivalent to the down-conversion of an RF band between 1.55 to 1.70 GHz), the measured quadrature error (in degrees) vs. input $f_{VCO}$ for $P_{VCO}$ = 0 dBm, is shown in **Figure 15.** All data is plotted versus the frequency that was applied to the fVCO port of the chip. Note that a quadrature error of less than 2° is achieved over the entire frequency range.

The equivalent unwanted image suppression of this down-conversion system has been calculated based on the measured phase and amplitude mismatch, and is presented in the graph of **Figure 16**, Unwanted Image Suppression vs. Input $f_{VCO}$ for Pvco = 0 dBm.

As stated, the HRMs **136** are utilized to reduce the mixer products generated as a result of the 3rd and 5th harmonic outputs from the divide-by-four circuit. These are situated at 3/4 x RFcarrier and 5/4 x RFcarrier, and mix with the input LO, at 3/4 x RFcarrier to generate unwanted products at the following fractions of the RFcarrier: 1/2, 3/2, and 2; these products were measured to be -36 dBc, -51 dBc, and -49 dBc, respectively.

A summary of measured results is as follows:

**TABLE IV - Summary of Measured Results for CMOS Implementation**

| | |
|---|---|
| Total power consumption at 1.8 V | 45 mW |
| Core LO circuit power consumption at 1.8 V | 27 mW |
| RF band | 1.55 ~ 1.70 Ghz |
| fVCO range required | 1.16 ~ 1.28 Ghz |
| Quadrature error (PVCO = 0 dBm) | < 2° |
| Amplitude mismatch (PVCO = 0 dBm) | < 0.37 dB |
| Equivalent Unwanted Image Suppression > | 32 dB |
| LO-RF leakage (0 dBm applied at 1.23 GHz) | -86 dBm at 1.64 GHz at mixer inputs |
| RF-LO leakage (-10 dBm at 1.64 GHz) | -72 dBm |
| Harmonic rejection at:      1/2 x RFcarrier | -36 dBc |
|                  3/2 x RFcarrier | -51 dBc |
|                 2 x RFcarrier | -49 dBc |
| Circuit Area (excluding pad frame) | 1.5 mm$^2$ |
| Technology | 0.18 μm CMOS |

A VCO frequency of 3/4 x RFcarrier, or 1.16 to 1.28 GHz, is needed, to operate in an RF band from 1.55 to 1.70 GHz and generate the required LO for direct conversion or low-IF architectures. A phase error of less than 2°, with greater than an equivalent 32 dB image suppression is achieved across this band. An LO-RF leakage of -86 dBm was measured at the mixer input ports.

While this example was done using direct conversion, the system could also be used in a low-IF architecture.

**Advantages of the Invention**

The invention provides many advantages over other down convertors known in the art. To begin with, it offers:

1. minimal 1/f noise;
2. minimal imaging problems;
3. minimal leakage of a local oscillator (LO) signal into the RF output band;
4. removes the necessity of having a second LO as required by super-heterodyne circuits, and various (often external) filters; and
5. has a higher level of integration as the components it does require are easily placed on an integrated circuit. For example, no large capacitors or sophisticated filters are required.

A high level of integration results in decreased IC (integrated circuit) pin counts, decreased signal power loss, decreased IC power requirements, improved SNR (signal to noise ratio), improved NF (noise factor), and decreased manufacturing costs and complexity.

The benefits of the invention are most apparent when it is implemented within a single-chip design, eliminating the extra cost of interconnecting semiconductor integrated circuit devices, reducing the physical space they require and reducing the overall power consumption. Increasing levels of integration have been the driving impetus towards lower cost, higher volume, higher reliability and lower power consumer electronics since the inception of the integrated circuit. This invention will enable communications devices to follow the same integration route that other consumer electronic products have benefited from.

**Options and Alternatives**

A number of variations can be made to the topology of the invention including the following:

1. the invention can be implemented using bipolar technology, CMOS technology, BiCMOS technology, or another semiconductor technology including, but not limited to Silicon/Germanium (SiGe), Germanium (Ge), Gallium Arsenide (GaAs), and Silicon on Sapphire (SOS);
2. the invention may be applied to various communication protocols and formats including: amplitude modulation (AM), frequency modulation (FM), frequency shift keying (FSK), phase shift keying (PSK), cellular telephone systems including analogue and digital systems such as code division multiple access (CDMA), time division multiple access (TDMA) and frequency division multiple access (FDMA); and
3. the mixers used in the topology of the invention could either be passive or active. Active mixers are distinct from passive mixers in a number of ways:

a. they provide conversion gain. Thus, an active mixer can replace the combination of a low noise amplifier and a passive mixer;
b. active mixers provide better isolation between the input and output ports because of the impedance of the active components; and
c. active mixers allow a lower powered mixing signal to be used, reducing the noise that results when the mixing signal is generated.

**Conclusions**

While particular embodiments of the present invention have been shown and described, it is clear that changes and modifications may be made to such embodiments without departing from the true scope of the invention.

The electrical circuits of the invention may be described by computer software code in a simulation language, or hardware development language used to fabricate integrated circuits. This computer software code may be stored in a variety of formats on various electronic memory media including computer diskettes, CD-ROM, Random Access Memory (RAM) and Read Only Memory (ROM). As well, electronic signals representing such computer software code may also be transmitted via a communication network.

The invention may be applied to various communication protocols and formats including: amplitude modulation (AM), frequency modulation (FM), frequency shift keying (FSK), phase shift keying (PSK), cellular telephone systems including analogue and digital systems such as code division multiple access (CDMA), time division multiple access (TDMA) and frequency division multiple access (FDMA).

The invention may be applied to such applications as wired communication systems include computer communication systems such as local area networks (LANs), point to point signalling, and wide area networks (WANs) such as the Internet, using electrical or optical fibre cable systems. As well, wireless communication systems may include those for public broadcasting such as AM and FM radio, and UHF and VHF television; or those for private communication such as cellular telephones, personal paging devices, wireless local loops, monitoring of homes by utility companies, cordless telephones including the digital cordless European telecommunication (DECT) standard, mobile radio systems, GSM and AMPS cellular telephones, microwave backbone networks, interconnected appliances under the Bluetooth standard, and satellite communications.

**Claims**

1. A demodulation circuit for down-converting an input signal RF, comprising:

   a synthesizer circuit (RD) for generating complementary sin and cos oscillator signals from an input oscillator signal x(t), and having
   a divider (40, 54) having an input and generating divided sin and cos outputs based on a signal received at said input;
   a first mixer (42, 58) for receiving said input oscillator signal x(t), and mixing said input oscillator signal x(t) with said sin output of said divider to generate an output signal;
   a second mixer (46, 60) for receiving said input oscillator signal x(t), and mixing said input oscillator signal x(t) with said cos output of said divider to generate an output signal;
   a first removal means (44, 66) for receiving said output signal of said first mixer and removing undesired frequency signals from said output signal, providing said frequency-shifted cos oscillator signal as an output;
   the cos output of said first removal means also being connected to the input of said divider; and
   a second removal means (48, 68) for receiving said output signal of said second mixer and removing undesired frequency signals from said output signal, thus providing said frequency-shifted sin oscillator signal as an output;
   first (96) and second (98) signal generators for receiving said complementary sin and cos oscillator signals from said synthesizer circuit;
   said first signal generator (96) for generating a multi-tonal mixing signal $\varphi 1$; and
   said second signal generator (98) for generating a mono-tonal mixing signal $\varphi 2$, the multi-tonal mixing signal $\varphi 1$ and the mono-tonal mixing signal $\varphi 2$ together defining virtual local oscillator signals that emulate a local oscillator signal;
   a third mixer (82) for receiving said input signal RF, and mixing said input signal RF with a multi-tonal mixing signal $\varphi 1$, to generate an output signal $\varphi 1$ RF; and
   a fourth mixer (86) for receiving said output signal $\varphi 1$ RF as an input, and mixing said output signal $\varphi 1$ RF with the mono-tonal mixing signal $\varphi 2$, to generate an output signal $\varphi 1$ $\varphi 2$ RF;
   where $\varphi 1 * \varphi 2$ has significant power at the frequency of a local oscillator signal being emulated, and neither of said $\varphi 1$ nor said $\varphi 2$ having significant power at the carrier frequency of said input signal RF or said local oscillator signal being emulated.

2. The circuit of claim 1, wherein said first signal generation circuit includes an exclusive-OR gate (XOR).

3. The circuit of claim 1, wherein each of said third and fourth mixers comprises a differential device.

4. The circuit of claim 1, wherein each of said third and fourth mixers comprises a harmonic rejection mixer.

5. The circuit of claim 1, further comprising a high pass filter electrically connected between said third mixer and said fourth mixer.

6. The circuit of claim 1, wherein said first and second removal means comprise first and second filters.

7. The circuit of claim 6, wherein said first and second filters comprise first and second band pass filters.

8. The circuit of claim 6, wherein said first and second filters comprise first and second notch filters.

9. The circuit of claim 1, wherein said divider comprises a divide-by-n divider.

10. The circuit of claim 9, wherein said divider comprises a divide-by-four divider.

**11.** The circuit of claim 1, wherein said first and second removal means comprise first and second harmonic subtraction circuits.

**12.** The circuit of claim 11, further comprising a polyphase filter (52) for filtering said input signal x(t) prior to feeding said input signal x(t) into said first and second mixers.

**13.** The circuit of claim 11, wherein each of said first and second mixers comprises a harmonic rejection mixer.

**Patentansprüche**

**1.** Demodulationsschaltung für eine Abwärtswandlung eines Eingangssignals RF, mit:

einer Syntheseschaltung (RD) zum Erzeugen komplementärer sin- und cos-Oszillatorsignale aus einem Eingangs-Oszillatorsignal x(t), und mit
einem Teiler (40, 54), der einen Eingang aufweist und basierend auf einem an seinem Eingang erhaltenen Signal geteilte sin- und cos-Ausgangssignale erzeugt;
einem ersten Mischer (42,58) zum Erhalten des Eingangs-Oszillatorsignals x(t) und Mischen des Eingangs-Oszillatorsignal x(t) mit dem sin-Ausgangssignal des Teilers, um ein Ausgangssignal zu erzeugen;
einem zweiten Mischer (46, 60) zum Erhalten des Eingangs-Oszillatorsignals x(t) und Mischen des Eingangs-Oszillatorsignals x(t) mit dem cos-Ausgangssignal des Teilers, um ein Ausgangssignal zu erzeugen;
einem ersten Beseitigungsmittel (44,66) zum Erhalten des Ausgangssignals des ersten Mischers und Entfernen ungewünschter Frequenzsignale aus dem Ausgangssignal, wobei das Frequenz veränderte cos-Oszillatorsignal als ein Ausgangssignal bereitgestellt wird;

wobei der cos-Ausgang des ersten Beseitigungsmittels auch mit dem Eingang des Teilers verbunden ist; und
einem zweiten Beseitigungsmittel (48, 68) zum Erhalten des Ausgangssignals von dem zweiten Mischer und Entfernen ungewünschter Frequenzsignale aus dem Ausgangssignal, womit das Frequenz veränderte sin-Oszillatorsignal als ein Ausgangssignal bereitgestellt wird;
einem ersten (96) und zweiten (98) Signalgenerator zum Erhalten komplementärer sin- und cos-Oszillatorsignale von der Syntheseschaltung;
wobei der erste Signalgenerator (96) zum Erzeugen eines Mehrton-Mischsignals φ1 vorgesehen ist; und
wobei der zweite Signalgenerator (98) zum Erzeugen eines Monoton-Mischsignals φ2 vorgesehen ist, wobei das Mehrton-Mischsignal φ1 und das Monoton-Mischsignal φ2 zusammen virtuelle lokale Oszillatorsignale bilden, die ein lokales Oszillatorsignal nachbilden;
einem dritten Mischer (82) zum Erhalten des Eingangssignals RF und Mischen des Eingangssignals RF mit einem Multiton-Mischsignal φ1, um ein Ausgangssignal φ1 RF zu erzeugen; und
einem vierten Mischer (86) zum Erhalten des Ausgangssignals φ1 RF als ein Eingangssignal und Mischen des Ausgangssignals φ1 RF mit dem Monoton-Mischsignal φ2, um ein Ausgangssignal φ1 φ2 RF zu erzeugen;
in welchem φ1 * φ2 bei der Frequenz, mit der ein lokales Oszillatorsignal nachgebildet wird, eine signifikante Stärke hat und weder φ1 noch φ2 bei der Trägerfrequenz des Eingangssignals RF oder des nachgebildeten lokalen Oszillatorssignals eine signifikante Stärke haben.

**2.** Schaltung nach Anspruch 1, in welcher die erste Signal-Erzeugungsschaltung ein Exklusiv-ODER-Gatter (XOR) enthält.

**3.** Schaltung nach Anspruch 1, in welcher jeder des dritten und vierten Mischers eine Differenziereinrichtung umfasst.

**4.** Schaltung nach Anspruch 1, in welcher jeder des dritten und vierten Mischers einen Oberwellenunterdrückungs-Mischer umfasst.

**5.** Schaltung nach Anspruch 1, ferner mit einem Hochpassfilter, der zwischen dem dritten Mischer und dem vierten Mischer elektrisch angeschlossen ist.

**6.** Schaltung nach Anspruch 1, in welcher das erste und zweite Beseitigungsmittel einen ersten und zweiten Filter umfasst.

**7.** Schaltung nach Anspruch 6, in welcher der erste und zweite Filter einen ersten und zweiten Bandpassfilter umfasst.

14

**8.** Schaltung nach Anspruch 6, in welcher der erste und zweite Filter einen ersten und zweiten Kerbfilter umfasst.

**9.** Schaltung nach Anspruch 1, in welcher der Teiler einen durch n teilenden Teiler umfasst.

**10.** Schaltung nach Anspruch 9, in welcher der Teiler einen durch Vier teilenden Teiler umfasst.

**11.** Schaltung nach Anspruch 1, in welcher das erste und zweite Beseitigungsmittel eine erste und zweite Oberwellen-Substraktionsschaltung umfasst.

**12.** Schaltung nach Anspruch 11, ferner mit einem Mehrphasenfilter (52) zum Filtern des Eingangssignals x(t) vor dem Zuführen des Eingangssignals x(t) in den ersten und zweiten Mischer.

**13.** Schaltung nach Anspruch 11, in welcher jeder des ersten und zweiten Mischers einen Oberwellenunterdrückungs-Mischer umfasst.

## Revendications

**1.** Un circuit de démodulation pour conversion descendante d'un signal d'entrée radiofréquence (RF), comprenant :

un circuit synthétiseur (RD) pour générer des signaux d'oscillateur sinusoïdal et cosinusoïdal complémentaires à partir d'un signal d'oscillateur d'entrée x(t), et ayant
un diviseur (40,54) ayant une entrée et générant des sorties sinusoïdale et cosinusoïdale divisées sur la base d'un signal reçu à ladite entrée ;
un premier mélangeur (42,58) pour recevoir ledit signal d'oscillateur d'entrée x(t), et mélanger ledit signal d'oscillateur d'entrée x(t) avec ladite sortie sinusoïdale dudit diviseur pour générer un signal de sortie ;
un deuxième mélangeur (46,60) pour recevoir ledit signal d'oscillateur d'entrée x(t), et mélanger ledit signal d'oscillateur d'entrée x(t) avec ladite sortie cosinusoïdale dudit diviseur pour générer un signal de sortie ;
un premier moyen d'élimination (44,66) pour recevoir ledit signal de sortie dudit premier mélangeur et éliminer des signaux de fréquence indésirable dudit signal de sortie, fournissant ledit signal d'oscillateur cosinusoïdal décalé en fréquence en sortie ;
la sortie cosinusoïdale dudit premier moyen d'élimination étant aussi reliée à l'entrée dudit diviseur ; et
un deuxième moyen d'élimination (48,68) pour recevoir ledit signal de sortie dudit deuxième mélangeur et éliminer des signaux de fréquence indésirable dudit signal de sortie, fournissant ainsi ledit signal d'oscillateur sinusoïdal décalé en fréquence en sortie ;
un premier (96) et un deuxième (98) générateurs de signaux pour recevoir lesdits signaux d'oscillateur sinusoïdal et cosinusoïdal complémentaires dudit circuit synthétiseur ;
ledit premier générateur de signaux (96) pour générer un signal de mélange multi-tonal φ1 ; et ledit deuxième générateur de signaux (98) pour générer un signal de mélange mono-tonal φ2, le signal de mélange multi-tonal φ1 et le signal de mélange mono-tonal φ2 définissant ensemble des signaux d'oscillateur locaux virtuels qui émulent un signal d'oscillateur local ;
un troisième mélangeur (82) pour recevoir ledit signal d'entrée RF, et mélanger ledit signal d'entrée RF avec un signal de mélange multi-tonal φ1, pour générer un signal de sortie φ1 RF ; et
un quatrième mélangeur (86) pour recevoir ledit signal de signal φ1 RF en entrée, et mélanger ledit signal de sortie φ1 RF avec le signal de mélange mono-tonal φ2, pour générer un signal de sortie φ1 φ2 RF ;

dans lequel φ1 * φ2 a une puissance significative à la fréquence d'un signal d'oscillateur local étant émulé, et aucun de φ1 ou de φ2 n'ayant une puissance significative à la fréquence porteuse dudit signal d'entrée RF ou dudit signal d'oscillateur local étant émulé.

**2.** Le circuit de la revendication 1, dans lequel ledit premier circuit de génération de signaux inclut une porte OU exclusive (XOR).

**3.** Le circuit de la revendication 1, dans lequel chacun desdits troisième et quatrième mélangeurs comprend un dispositif différentiel.

**4.** Le circuit de la revendication 1, dans lequel chacun desdits troisième et quatrième mélangeurs comprend un mélangeur à rejet d'harmonique.

**5.** Le circuit de la revendication 1, comprenant en outre un filtre passe haut relié électriquement entre ledit troisième mélangeur et ledit quatrième mélangeur.

**6.** Le circuit de la revendication 1, dans lequel lesdits premier et deuxième moyens d'élimination comprennent des premier et deuxième filtres.

**7.** Le circuit de la revendication 6, dans lequel lesdits premier et deuxième filtres comprennent des premier et deuxième filtres passe bande.

**8.** Le circuit de la revendication 6, dans lequel lesdits premier et deuxième filtres comprennent des premier et deuxième filtres à encoches.

**9.** Le circuit de la revendication 1, dans lequel ledit diviseur comprend un diviseur divisant par n.

**10.** Le circuit de la revendication 9, dans lequel ledit diviseur comprend un diviseur divisant par 4.

**11.** Le circuit de la revendication 1, dans lequel lesdits premier et deuxième moyens d'élimination comprennent des premier et deuxième circuits de soustraction d'harmonique.

**12.** Le circuit de la revendication 11, comprenant en outre un filtre polyphasé (52) pour filtrer ledit signal d'entrée x(t) avant d'amener ledit signal d'entrée x(t) dans lesdits premier et deuxième mélangeurs.

**13.** Le circuit de la revendication 11, dans lequel chacun desdits premier et deuxième mélangeurs comprend un mélangeur à rejet d'harmonique.

FIGURE 1 - PRIOR ART

**FIGURE 2 - PRIOR ART**

sin(2πft)

42

filter @ [4/3]f
44

cos(2π[4/3]ft)

sin(2π[1/3]ft)

DIVIDED
BY 4

cos(2π[1/3]ft)

40

46

filter @ [4/3]f

sin(2π[4/3]ft)

48

**FIGURE 3**

EP 1 590 886 B1

**FIGURE 4**

**FIGURE 5**

EP 1 590 886 B1

FIGURE 6

EP 1 590 886 B1

FIGURE 7

$\phi 1$

$\phi 2$

$\phi 1 \bullet \phi 2$

~100

XOR → phi1_I

I

LO → RD

SQUARE WAVE ~100

94

Q

XOR → phi1_Q

102

# FIGURE 8

cos(2π[1/3]ft)

sin(2πft) → ⊗ → ⊕ → OUT

60        68

sin(2πft) → ⊗

62

sin(2π[1/3]ft)

# FIGURE 9

**FIGURE 10**

EP 1 590 886 B1

**FIGURE 11**

**FIGURE 12**

FIGURE 13

EP 1 590 886 B1

**FIGURE 14**

## Quadrature Error vs. Input f$_{VCO}$ for P$_{VCO}$ = 0 dBm

**FIGURE 15**   VCO frequency = 3/4 x RF$_{carrier}$ (GHz)

## Unwanted Image Suppression vs. Input f$_{VCO}$ for P$_{VCO}$ = 0 dBm

**FIGURE 16**   VCO frequency = 3/4 x RF$_{carrier}$ (GHz)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CA 0000995 W
- CA 0000994 W
- CA 0000996 W
- CA 0100876 W

### Non-patent literature cited in the description

- **F. Behbahani et al.** CMOS Mixers and Polyphase Filters for Large Image Rejection. *IEEE J. Solid-State Circuits,* June 2002, vol. 36, 873-886
- **A. Niknejad ; R. Meyer.** Analysis, Design, and Optimization of Spiral Inductors and Transformers for RF IC's. *IEEE J. Solid-State Circuits,* October 1998, vol. 33, 1470-1481
- **J. A. Weldon.** A 1.75-GHz Highly Integrated Narrow-Band CMOS Transmitter with Harmonic-Rejection Mixers. *IEEE J. Solid- State Circuits,* December 2001, vol. 36, 2003-2015